Europäisches Patentamt

**European Patent Office**

Office européen des brevets

(19)

(11) Numéro de publication : **0 129 508**
**B1**

(12)

# FASCICULE DE BREVET EUROPÉEN

(45) Date de publication du fascicule du brevet :
**21.01.87**

(21) Numéro de dépôt : **84810249.7**

(22) Date de dépôt : **22.05.84**

(51) Int. Cl.⁴ : **G 01 R 31/28**

(54) **Procédé d'examen et de test d'un dispositif électrique du type des circuits intégrés ou imprimés.**

(30) Priorité : **25.05.83 CH 2842/83**

(43) Date de publication de la demande :
**27.12.84 Bulletin 84/52**

(45) Mention de la délivrance du brevet :
**21.01.87 Bulletin 87/04**

(84) Etats contractants désignés :
**AT BE CH DE FR GB IT LI LU NL SE**

(56) Documents cités :
**FR-A- 2 058 756**
**GB-A- 2 069 152**
**US-A- 4 242 635**
**US-A- 4 358 732**
**ELECTRONICS, vol. 54, 14 juillet 1981, New York (US)**
**L. LOWE:"Lasers automate pc-board inspection",**
**pages 96, 98, 100**
**MICROELECTRONICS JOURNAL, vol. 11, no. 2, 1980,**
**Mackintosh Publications Ltd., Luton (GB) CH.E.**
**JOWETT:"Surface analytical techniques applied to**
**electronic components", pages 35-40**

(73) Titulaire : **BATTELLE MEMORIAL INSTITUTE**
**7 route de Drize**
**CH-1227 Carouge/Genève (CH)**

(72) Inventeur : **Pau, Louis F.**
**5, chemin de Tressy-Cordy**
**CH-1212 Grand-Lancy (CH)**

(74) Mandataire : **Dousse, Blasco et al**
**7, route de Drize**
**CH-1227 Carouge/Genève (CH)**

## Description

La présente invention se rapporte à un procédé d'examen et de test non destructif d'un dispositif électrique du type des circuits intégrés ou imprimés, ou d'un capteur utilisant les mêmes technologies selon lequel on détecte, par balayage, un rayonnement propre émis par ce dispositif consécutivement à sa stimulation, on forme des signaux électriques caractéristiques de ce rayonnement détecté et on compare ces signaux à des signaux de référence.

Il existe en micro-électronique une quantité de dispositifs réalisés selon la technique des circuits intégrés, essentiellement par lithographie, attaque chimique (photogravure) et métallisation dans des tranches de silicium, ou de composés III-V et II-VI du tableau périodique des éléments, telles les matrices de photo-détecteurs. Ces examens s'appliquent également aux circuits imprimés à couche simple ou multiple, aux tranches découpées dans des barreaux étirées de silice ou de composés III-V et II-VI du tableau périodique des éléments, aux circuits de micro-ondes obtenus par des techniques analogues à celles des tranches des circuits intégrés.

L'examen automatique des défauts de ce genre de dispositifs électriques et capteurs a déjà fait l'objet de nombreux travaux. Généralement, l'examen a été réalisé par la détection optique d'un rayonnement dans le domaine visible ou infra-rouge, généré ou réfléchi par le dispositif. C'est ainsi que dans le brevet US-3-803 413, on soumet un circuit imprimé à un signal d'excitation qui est soit une tension continue, soit une tension modulée ou impulsionnelle, on détecte à l'aide d'un mécanisme de balayage le rayonnement infra-rouge émis par les différents éléments du circuit et on compare la densité du rayonnement en chaque point du circuit avec une référence, ce qui permet de détecter des défauts liés à l'échauffement par effet Joule des différentes métallisations composant ce circuit.

Il existe également des procédés utilisant la technique de corrélation optique d'images en analysant le rayonnement optique réfléchi par la surface du circuit. C'est notamment le cas des demandes EP-66 321 et 66 694.

Le premier procédé mentionné permet de relever des défauts essentiellement relatifs au dimensionnement des composants. Les procédés utilisant la réflexion permettent de détecter des défauts dans la géométrie du circuit ou des contraintes s'exerçant au niveau de la surface, par exemple consécutivement à une distorsion du substrat ou de la tranche.

Par contre, ces procédés d'inspection ne permettent pas de détecter des défauts de structure, notamment aux interfaces entre les différentes couches, ainsi que des défauts au niveau du substrat, du fait qu'ils ne se traduisent pas forcément par une émission anormale d'infrarouges lors du passage d'un signal électrique déterminé, ni par la seule réflexion ou diffusion d'un rayonnement incident.

On a déjà proposé d'utiliser un microscope à balayage électronique (SEM) pour former une image par captage des électrons émis consécutivement au balayage électronique. Cette technique présente plusieurs inconvénients, en particulier pour effectuer des tests de production, du fait qu'elle nécessite de placer les dispositifs électriques à tester dans une enceinte à vide, à les recouvrir d'une couche de dépôt métallique, ce qui exclut l'utilisation systématique ou rapide de ce procédé sur des grandes séries en production. Ce mode d'irradiation ne permet pas un test électrique simultané à des vitesses compatibles avec les délais de fabrication. Ce type d'examen fait notamment l'objet du US-A-4 358 732 ainsi que du FR-A-2 058 756. Dans ce dernier document, on procède simultanément et en synchronisme avec le bombardement d'électrons à des tests électriques pulsatoires. Ce type de test ne permet pas de localiser des défauts de structure, mais d'obtenir des indications relatives aux performances du circuit testé, et est lent.

Le GB-A-2 069 152 est relatif à un procédé pour tester des circuits intégrés selon lequel le circuit est alimenté par une tension réduite à une valeur légèrement supérieure à la tension marginale à laquelle des défauts du circuit provoquent des écarts de tension à la sortie du circuit lorsqu'un test logique lui est appliqué. Lorsqu'un faisceau de radiations balaye la surface, les défauts se manifestent dans la caractéristique du courant photoélectrique résultant et peuvent ainsi être détectés mais non localisés. Ce procédé n'envisage pas la visualisation des défauts par l'exploitation du rayonnement réémis ou transmis par ce circuit, de sorte que tous les défauts structurels ne sont pas localisables.

On sait que physiquement la présence de discontinuités dans la matière soumise à l'excitation d'un rayonnement incident, provoque une interaction entre ce rayonnement et ces discontinuités qui se traduit par une conversion du mode d'excitation aux interfaces.

Lorsqu'un faisceau incident frappe un semiconducteur ou une interface, il engendre des paires électrons-trous. Si ces porteurs mobiles atteignent ou viennent de la région d'appauvrissement de la jonction p-n, ils sont balayés par l'existence du potentiel de jonction, engendrant un courant inverse externe qui se superpose à celui induit par la tension extérieure du test électrique. En collectant et en amplifiant ce courant, on obtient une information relative à l'état électrique des jonctions traversées ou à des variations dans les caractéristiques de la jonction.

En outre, lors de l'excitation par un rayonnement incident d'une structure à couches multiples de conductibilités électriques différenciées, dont au moins une couche est le siège d'un transport d'électrons, ce transport d'électrons provoque une stimulation de la conversion du mode d'excitation, qui se produit aux interfaces des couches de cette structure et se traduit par l'induction d'un rayonnement (dit rayonnement secondaire). En outre, l'interaction entre le rayonnement et le signal électrique générateur du transport d'électrons provoque une modification de la réponse de ce signal.

La présente invention se propose d'exploiter ces phénomènes physiques pour détecter des défauts au niveau de la structure des dispositifs électroniques, au niveau des interfaces (interfaces/métallisations — substrat compris), aussi bien que certains défauts à l'intérieur des substrats eux-mêmes.

A cet effet, la présente invention a pour objet un procédé selon la revendication 1.

Un tel procédé permet de recueillir une quantité importante d'informations en un temps très court. Ces informations ne sont pas relatives qu'à la géométrie, mais aussi aux défauts dans la structure et en particulier au niveau de la microstructure. Comme on le verra par la suite, les sources d'excitations par rayonnement peuvent être choisies notamment en fonction du type de défauts à détecter, plusieurs sources différentes pouvant être utilisées simultanément et les rayonnements secondaires, induits par l'interaction de chaque rayonnement incident avec la structure qui est le siège d'un transport d'électrons, étant détectés par des détecteurs respectifs, appropriés à la nature de ces rayonnements secondaires induits.

La phase du procédé relative au traitement des signaux électriques caractéristiques, des rayonnements induits détectés, utilise des algorithmes relevant des techniques de reconnaissance d'images qui sortent du cadre de la présente invention et ne seront pas abordées de ce fait dans la description qui va suivre.

Le dessin annexé illustre, très schématiquement et à titre d'exemple, une forme d'exécution et une variante d'un mode de mise en œuvre du procédé objet de l'invention.

La figure 1 est un schéma explicatif d'une unité d'examen d'un dispositif électrique pour la mise en œuvre de ce procédé.

La figure 2 est un schéma d'une variante de la fig. 1.

La figure 3 est un schéma des types de rayonnement secondaires réémis.

La figure 4 est un schéma des zones d'excitation primaires où sont engendrées les émissions secondaires.

La figure 5 est un schéma bloc d'une unité d'examen (test et injection).

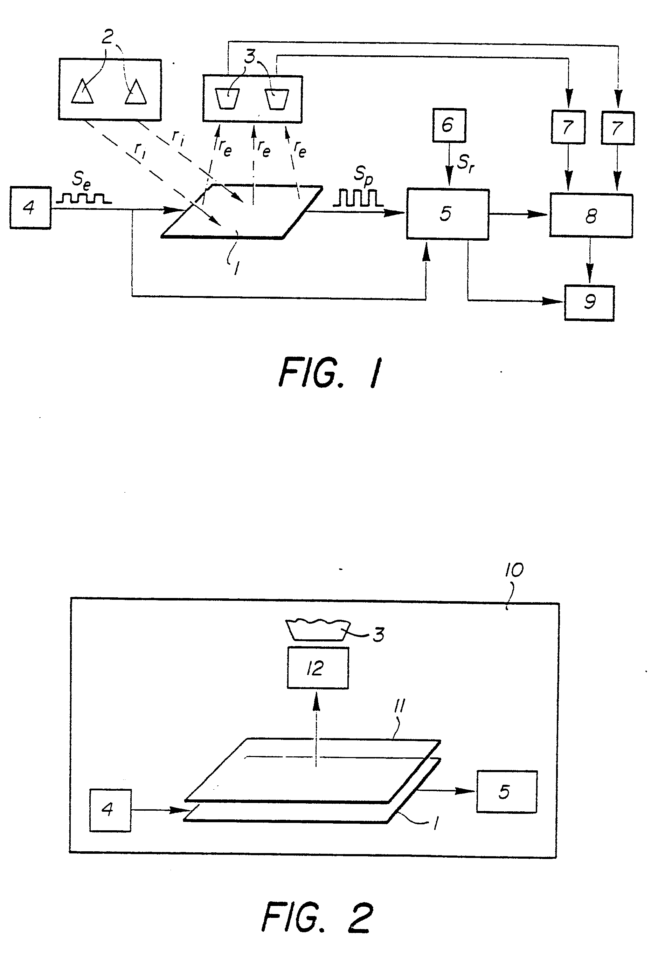

L'unité d'examen illustrée par la fig. 1 comporte un dispositif électrique 1 à tester, au moins un source de rayonnement 2 pour produire un rayonnement incident $r_i$ dirigé contre la surface du dispositif électrique, au moins un détecteur 3 destiné à capter le rayonnement secondaire $re_e$, émis consécutivement à l'excitation du dispositif électrique 1. Ce dispositif 1 est connecté à une source électrique 4 destinée à produire un signal électrique déterminé qui peut être constitué par une impulsion, un signal modulé, voire une tension continue. La sortie de cette source électrique 4 est également connectée à un module de comparaison 5 destiné à comparer le signal $S_p$, produit à la sortie du dispositif électrique 1, avec un signal de référence $S_r$ mémorisé dans une mémoire 6.

Le ou les détecteurs 3 transforment le rayonnement secondaire capté $R_e$ en un signal électrique caractéristique de ce rayonnement et le transmettent à un module de formation d'image 7 consécutivement au balayage du dispositif électrique 1 à examiner. Les techniques de balayage sont bien connues et ne seront ni décrites, ni représentées ici. Il est simplement précisé qu'un balayage du rayonnement d'excitation de la source 2 avec miroir tournant actionné par un moteur peut être utilisé avec un balayage électronique du capteur 3. Les images issues des modules de formations d'image 7 sont transmises à un module 8, destiné à centraliser l'information du module de comparaison 5 et des modules de formation d'images 7 et à déceler les défauts sur les images transmises. L'information qui en ressort est transmise finalement à un module de décision 9 qui détermine dans quelle mesure le dispositif électrique 1 testé et examiné correspond à des normes prédéterminées.

Le procédé objet de l'invention se rapporte essentiellement au mode d'excitation conjoint (rayonnement incident $r_i$ et tension de la source 4) du dispositif électrique 1 à tester et à examiner et plus particulièrement à l'irradiation de ce dispositif conjointement au transport d'électrons généré par le signal d'excitation $S_e$ issu de la source électrique 4.

La ou les sources de rayonnement 2 choisies permettent de faire apparaître différents types de défauts dans la structure du dispositif électrique 1 examiné, de même qu'elles permettent, dans certains cas d'influer sur le signal de réponse $S_p$, produit à la sortie du dispositif électrique 1.

Lorsque l'on soumet un dispositif électrique à structure multicouches dont au moins une couche est traversée par un transport d'électrons, à un rayonnement d'excitation, le rayonnement total induit par la double excitation du rayonnement incident et du signal électrique $S_e$ générateur du transport d'électrons est composé de la partie réfléchie du rayonnement incident, de la partie diffractée de ce même rayonnement, du rayonnement propre de la matière irradiée induit conjointement à l'excitation électrique, ainsi que du rayonnement propre de la matière dû à l'excitation électrique seule.

La partie la plus intéressante du rayonnement induit par cette double excitation est le rayonnement secondaire propre de la matière irradiée induit conjointement à l'excitation électrique en raison du phénomène d'interaction rayonnement-matière en présence de discontinuités dans la structure. Or, un circuit intégré, un circuit imprimé, un capteur monolithique, voire les substrats de tels circuits sont essentiellement formés de couches adjacentes, donc de structures discontinues qui sont le siège du phénomène d'interaction rayonnement-matière lorsque ces structures sont soumises à un rayonnement d'excitation, dû à la conversion du mode d'excitation aux interfaces de cette structure. Or, il se trouve que cette conversion est stimulée lorsqu'au moins une de ses couches est traversée par un transport d'électrons dû à un signal d'excitation.

Le procédé selon l'invention s'applique aussi aux empilements obtenus par croissance épitaxiale de couches minces alternativement de l'un ou l'autre de deux substrats semiconducteurs (ex GaP ou InP et GaAsP ou InAsP). Ces empilements produisent une photoluminescence forte lorsqu'ils sont excités. Ce procédé s'applique également aux semiconducteurs à l'arsénure de gallium (GaAs) ou en phosphure d'indium (InP).

Nous examinerons ci-après différents types d'excitation par rayonnement, ainsi que la nature des défauts qu'ils sont appelés à révéler :

## Exemple 1

L'excitation électrique est combinée avec une irradiation à l'aide d'un laser à ions CW pulsé (0,5 $MW/cm^2$ et $2kA/cm^2$). Ce type d'excitation permet de détecter une contamination de surface, la présence de particules étrangères, une matrice fendue, des rayures, soit par la luminescence dans la gamme infrarouge 0,8-3 $\mu$m provoquée par la densité de porteurs générés optiquement dans la recombinaison rayonnante bande à bande de dopants défectueux, soit dans des modifications de la lumière filtrée dispersée dans l'espace. Il permet également de détecter des imperfections de la structure cristalline par la luminescence dans la gamme infrarouge 0,8-3 $\mu$m provoquée par la densité de porteurs positifs dans la recombinaison rayonnante bande à bande de dopants défecteux. Ce type d'irradiation combiné à l'excitation électrique est encore utilisable pour faire apparaître les erreurs d'alignement et les erreurs de masques, les discontinuités de métallisation et les pistes ou conducteur interrompus en faisant usage de la correspondance de l'image détectée avec une image de référence et par l'extraction de traits caractéristiques, d'après la densité de porteurs générés optiquement, le courant ne circulant pas, ou apparaissant au mauvais endroit. Enfin, ce type de rayonnement est capable de mettre en évidence des distorsions de surfaces planes et à nouveau des discontinuités de métallisation, par la mise en concordance de l'image ou de son balayage avec des caractéristiques d'une image de référence.

## Exemple 2

L'excitation électrique de la source 4 peut être utilisée simultanément à une source de lumière infra-rouge polarisée ou à une source infra-rouge pour détecter des imperfections dans la structure cristalline, des fentes de matrice et des rayures, des ruptures d'oxyde et des attaques de matrice par biréfringence provoquée par les contraintes induites conjointement par les excitations thermique et électrique. Ce type d'excitation peut encore servir à détecter des anomalies de diffusion et des formations intermétalliques par absorption infrarouge résultant de réactions radio-chimiques stimulées. Les anomalies des diffusions, ainsi que les défauts de dopage peuvent encore être détectés par des recombinaisons de transition de $O_2$ et C dans le substrat, induites par irradiation stimulée. Enfin, les formations intermétalliques étant en relation avec la dislocation de la structure du noyau, des modifications de structure induisent des effets lorsqu'une contrainte thermique est appliquée permettant de détecter des formations intermétalliques.

## Exemple 3

L'excitation électrique de la source 4 est utilisée conjointement à un rayonnement isotrope en micro-ondes en particulier d'ondes millimétriques dans la région de 30-90 Giga Hz. Ce type d'excitation combinée permet, en mesurant des modifications de tension photoinduites caractéristiques de la capacité, de tracer un profil en fonction du temps, dans la réponse électrique fournie au module 5 et dans l'image détectée par le capteur 3, de détecter la présence de particules de matières étrangères, des anomalies de diffusion, des ruptures de métallisation, des migrations d'électrons. Le détecteur à ondes millimétriques, dans la région de 20-600 GHz peut être un détecteur à photoconduction à monocrystaux de telluride de cadmium/mercure ($[Hg_{x-1}, Cd_x]Te$) dans le mode à électrons chauds, On peut également mesurer la radiation infrarouge produite par la résistance en série des jonctions, induite par les courants d'excitation, pour détecter les imperfections de la structure cristalline, les anomalies de diffusion et les défauts de dopage. Par la corrélation de l'image produite par les modules 7 avec les traits caractéristiques de l'image de référence, on peut mettre en évidence des ruptures de pistes ou de conducteurs, des pistes déplacées et des distorsions de surfaces. Ce type d'excitation permet également de détecter les formations intermétalliques du fait que de tels composés sont en relation avec la dislocation de la structure du noyau, des modifications de structure induisent des effets lorsqu'une contrainte thermique est appliquée, se superposant aux effets acoustiques induits. Les anomalies de diffusion peuvent encore être détectées par résonance magnétique nucléaire (NMR) à niveau par micro-ondes ou par infra-rouges. Enfin, les formations intermétalliques et les dopants défectueux peuvent tous deux être révélés par des recombinaisons de transition de $O_2$ et C dans le substrat, induites par irradiation stimulée.

## Exemple 4

L'excitation électrique de la source 4 est appliquée conjointement à une irradiation par protons. La densité de porteurs générés par des protons produit des ondes thermiques se dispersant autour des défauts et permet de détecter des imperfections de cristaux, des matrices fendues et des rayures, des porosités dans les oxydes et des ruptures d'oxydes.

Exemple 5

L'excitation électrique de la source 4 est appliquée conjointement à un faisceau d'électrons pulsé de sorte que la densité des porteurs générés par des particules produit des ondes thermiques et électriques se dispersant autour des défauts et révèle des imperfections cristallines, des matrices fendues et des rayures.

Exemple 6

L'excitation électrique de la source 4 est appliquée conjointement à une irradiation neutronique. La luminescence induite par les taux de défauts chargés dans les semi-conducteurs à doublet libre permet de détecter des imperfections cristallines, des matrices fendues, des rayures, ainsi que des anomalies de diffusion.

Exemple 7

L'excitation électrique de la source 4 est appliquée conjointement à une irradiation ionique de 60 keV. La propagation guidée entre couches des ions incidents entre plans cristallins produit des électrons secondaires qui permettent de détecter des imperfections cristallines, des matrices fendues, des rayures, des porosités d'oxydes et des anomalies de diffusion.

Les sources ioniques donnent une information relative à la subsurface qui n'est pas facilement accessible aux microscopes électroniques. L'information en profondeur est seulement fournie par rétro-diffusion d'électrons secondaires énergétiques produits par des faisceaux ioniques provenant d'une diffusion de Rutherford dure des noyaux atomiques dans le substrat. Par conséquent, les faisceaux des ions incidents et les émissions d'électrons secondaires servent de sonde sensible de la structure sous-jacente de la cible. Des cascades de ces collisions dures de noyaux atomiques dans le substrat transportent l'information vers la surface, notamment aux jonctions électroniques du circuit intégré. Une perte de courant canal, (sensible à la direction des ions incidents) dans les couches semiconductrices du circuit intégré produit des images d'électrons secondaires à contraste élevé.

A titre d'exemple de sources de bombardement ionique, on peut utiliser des ions $Ga^+$ de gallium lourd de 60 keV d'énergie ou encore des ions $Ga^+$ de gallium liquide de 40 keV d'énergie.

Exemple 8

L'excitation électrique de la source 4 est appliquée conjointement à un faisceau laser à rayons X. La fluorescence photoinduite stimulée par rayons X permet de mettre en évidence la contamination de surface, les particules de matières étrangères, les fentes de matrices et les rayures, les erreurs d'alignements et de masques. Les ruptures de métallisations sont mises en évidence par la correspondance d'image et l'extraction de traits caractéristiques, selon la densité de porteurs générés optiquement, le courant ne circulant pas ou apparaissant aux mauvais endroits, ainsi que par la corrélation d'images à partir de traits caractéristiques de ces images.

Exemple 9

L'excitation électrique de la source 4 est appliquée conjointement à une irradiation d'une source à résonance magnétique nucléaire (NMR) qui permet de révéler les imperfections cristallines, les porosités d'oxydes et les anomalies de diffusion.

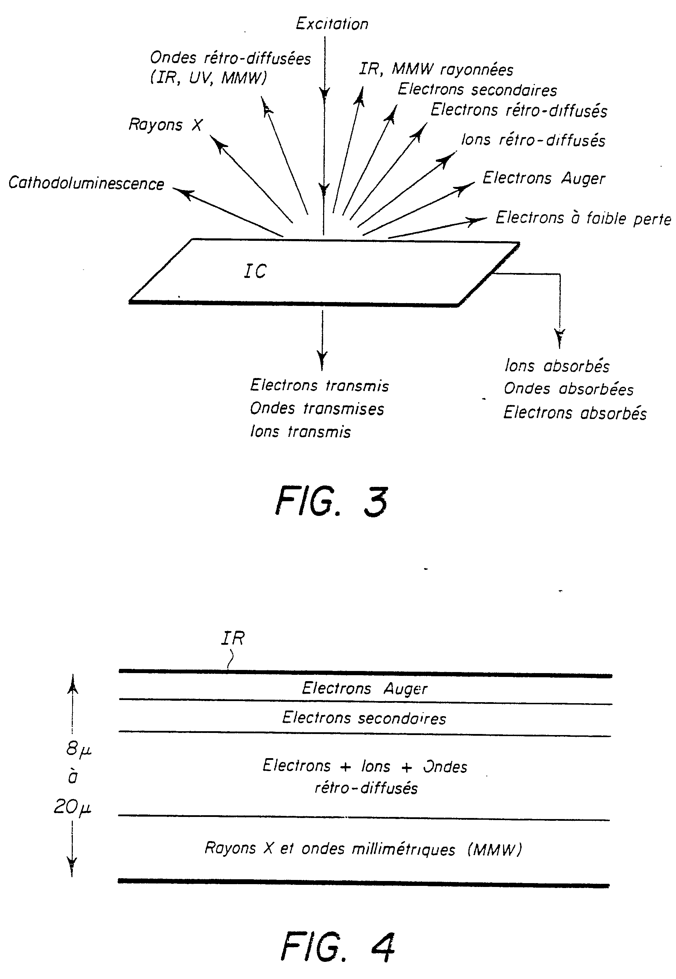

Le schéma de la fig. 3 représente les différents types de rayonnements qui peuvent être émis par le dispositif électrique à tester en fonction des différents modes d'irradiation utilisés et que nous avons énumérés ci-dessus. Il est important de noter au sujet de cette figure que l'image détectée peut l'être aussi bien par réflexion que par transparence à travers le circuit ; la transparence a lieu par exemple pour un faisceau laser de 1,15 µ ou par des rayons X doux. En outre, le rayonnement détecté (réfléchi ou transmis) comporte d'autres longueurs d'onde $\lambda_d$ que celles $\lambda_e$ du rayonnement d'excitation, et ces longueurs d'onde $\lambda_d$ peuvent être aussi bien supérieures qu'inférieures à celles du rayonnement d'excitation. Cette particularité présente deux avantages importants, celui d'éliminer les réflexions parasites aux longueurs d'onde $\lambda_e$ et surtout le fait que les émissions secondaires sont caractéristiques des transitions aux jonctions, de sorte que le spectre des longueurs d'onde $\lambda_d$ de ces émissions secondaires permet de mettre en évidence la nature des transitions qui les ont engendrées, et en particulier celles dues aux défauts de structure.

Il est en outre à préciser qu'avec un microscope à balayage électronique, on ne recueille que des électrons secondaires de faible énergie < 50 eV induits par un faisceau primaire d'électrons, alors que dans le cas de l'invention, aussi bien des photons que des électrons et ions secondaires peuvent être induits par exemple par un faisceau incident laser, par un faisceau d'ions ou d'ondes millimétriques.

Le schéma de la fig. 3 fait encore apparaître comme rayonnement secondaire les catholuminescences qui sont induites consécutivement à une irradiation d'électrons, d'ondes millimétriques et par laser ; de telles luminescences se font à certaines jonctions, et aussi bien dans la résine non correctement gravée.

Le schéma de la fig. 4 montre la profondeur des zones d'excitation primaires engendrant l'émission secondaire pour chaque mode de rayonnement induit.

Les émissions secondaires peuvent n'avoir lieu que pour certaines valeurs de la tension appliquées au circuit testé, typiquement pour une tension de polarisation de contrôle de OU ou près de la tension de blocage, ou choisies de manière appropriée selon la longueur des jonctions, les propriétés des substrats, métallisations, etc...

Il est précisé que la source de rayonnement 2 et l'excitation électrique destinée à tester électriquement le circuit, produite par la source 4, peuvent être synchronisées : l'illumination stroboscopique sert à bloquer la distribution spatiale des tensions et charges d'électrons dans des états logiques sélectionnés, en relation avec l'excitation électrique (en régime dynamique et périodique).

Un masque opaque 12 (fig. 2) peut être placé devant chaque détecteur 3, au point focal d'une lentille de ce détecteur pour empêcher la réflection spéculaire de la source de rayonnement 2 sur le dispositif 1 à examiner, d'atteindre les détecteurs 3.

Les différents modes de mise en œuvre susmentionnés peuvent être effectués dans des conditions de température, de pression du dispositif à examiner, ainsi que dans un environnement électromagnétique et chimique particuliers. C'est ainsi que le dispositif à examiner et la ou les sources de rayonnement 2, ainsi que le ou les détecteurs 3, peuvent être placés dans une enceinte hermétique 10 (fig. 2) dans laquelle se trouve un gaz à l'état gazeux ou liquide tel qu'un gaz neutre $N_2$ par exemple ou du $CO_2$ qui permet de créer un milieu chimiquement déterminé à une température contrôlée. L'apparition de points chauds peut engendrer une évaporation localisée se manifestant par la formation de bulles. L'enceinte 10 peut également servir de barrière absorbante des rayonnements électromagnétiques extérieurs à l'enceinte. Elle peut être munie d'une pompe à diffusion ou thermomoléculaire.

Il est également envisagé de déposer une couche 11 (fig. 2) sur le dispositif 1 à examiner en vue d'augmenter certains rayonnements secondaires $r_e$ émis par certaines zones de ce dispositif 1 lorsqu'il est soumis à l'excitation conjointe des sources 2 et 4 (fig. 1). C'est ainsi que si la couche 11 est formée de cristaux cholestériques ou nématiques, le détecteur 3 peut être formé d'une rangée ou matrice de trois détecteurs dans trois couleurs respectives. Les cristaux liquides de la couche 11 peuvent être dilués dans du pentane avec 0,05-2 % de lécithine. Les cristaux liquides cholestériques sensibles au champ électrique ou électrostatique localisé font tourner le plan de polarisation sur la lumière qu'ils transmettent ; à chaud, les cristaux ne font pas tourner la lumière polarisée et apparaissent de ce fait opaques.

La couche 11 (fig. 2) recouvrant le dispositif 1 à examiner peut également être une substance transparente formée par exemple de fluorescéine diluée dans du pentane avec 0,05-2 % de lécithine devenant fluorescente lorsqu'elle est excitée par une source laser UV ou X en raison de la combinaison de réactions électriques et photochimiques.

La courbe 11 peut encore être une substance transparente telle que fluorescéine devenant luminescente lorsqu'elle est excitée par une source 2 telle qu'une source de neutrons à faible énergie (2-50 eV) en raison de la combinaison des réactions électrique et photochimique.

Cette couche 11 peut encore être un fréon ou un fluocarbone liquéfié ou pulvérisé sensible à un échauffement localisé du dispositif 1 à examiner.

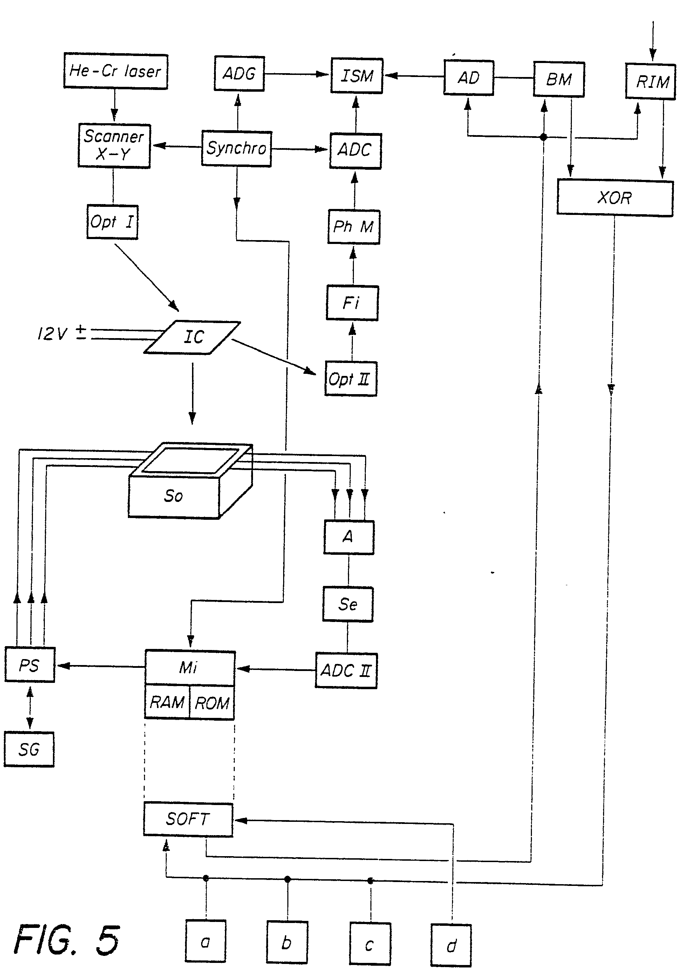

Le schéma-bloc de la fig. 5 est celui d'une installation qui a été utilisée en vue d'effectuer des tests sur des circuits intégrés IC.

La partie d'irradiation de cette installation comporte un laser He-Cr de 40 mW qui engendre un faisceau laser bleu monochromatique. Le laser est associé à un dispositif de balayage (scanner) selon un système de coordonnées X-Y associé à un module de synchronisation à impulsion d'horloge (synchro). Une optique (Opt.I) × 500-8 000 est interposée entre le dispositif de balayage (scanner) et le circuit intégré IC à tester. Ce circuit intégré IC est relié d'une part à une alimentation électrique à courant continu de 12 volts et, d'autre part, est connecté à un générateur de signaux (SG) par un socle (So) de connexion sur lequel il est placé lors des tests. Les signaux sont choisis par un sélecteur programmable (PS) commandé par un microprocesseur à 16 bits (Mi) connecté au module de synchronisation (Synchro).

Après avoir décrit les éléments de l'installation relatifs à l'irradiation et ceux relatifs à la stimulation électronique du circuit, nous allons décrire les éléments de détection du rayonnement secondaire et d'analyse des signaux résultant de la stimulation électrique.

L'émission polychrome secondaire résultant de l'irradiation du circuit intégré IC est captée par une optique (Opt. II) × 500-8 000. Les rayonnements polychromes sont alors filtrés à une longueur d'onde ⩾ 0,480 µ dans le module de filtrage (Fi) qui communique avec un photomultiplicateur (PhM). Le signal est ensuite converti d'analogique en digital par le module (ADC) de 8 bits qui alimente le module de stockage d'image (ISM) de 1 024 × 1 024 × 8 bits, connecté à un générateur d'adresses (ADG) associé au module de synchronisation (Synchro).

Les signaux électriques issus de la stimulation électrique par le générateur de signaux (SiGe) sont amplifiés entre 20 et 4 000 × par un amplificateur (A) qui est relié à un convertisseur analogique digital de $8^{\circ}$ bits (ADC II) par l'intermédiaire d'un sélecteur (Se). Les signaux issus du convertisseur (ADC II) sont transmis au microprocesseur (Mi), et ultérieurement à un logiciel (SOFT) pour analyse conjointe à celle de l'image traitée venant d'un système d'opération logique pour la comparaison d'images (XOR).

Une fois l'image stockée dans le module de stockage (ISM), elle est traitée par le système d'opérations logiques pour la comparaison d'images (XOR) qui est connecté, d'une part, à une mémoire d'images de référence (RIM) et, d'autre part, à une mémoire tampon (BM) qui est elle-même connectée au module de stockage d'image (ISM) par l'intermédiaire d'un décodeur d'adresses (AD). La sortie du système d'opérations logiques pour la comparaison d'images (XOR) transmet les différences détectées ou les parties d'images prétraitées au logiciel (SOFT) dont le programme de traitement sera expliqué par la suite. Cet ordinateur procède au transfert séquentiel de l'image traitée par le système de comparaison (XOR) dans celle du microprocesseur.

Le programme de l'ordinateur comporte quatre séquences illustrées par les rectangles (a), (b), (c), (d). (a) correspond à la localisation des défauts dans l'image traitée, (b) correspond à une vérification (fondée sur un ensemble de règles symboliques, selon les principes de l'intelligence artificielle) des défauts électriques et dans l'image, (c) correspond à la détection, à la localisation et au dimensionnement des défauts et (d) à la commande du test de stimulation électrique suivant.

Dans une variante d'exécution, un premier détecteur 3 peut être un détecteur infra-rouge à balayage ou à matrice ou rangée formée d'une mosaïque de capteurs, destiné à détecter les points, chauds par exemple de l'ordre de 50° à 60 °C engendrés par l'excitation électrique et dont la largeur de bande spectrale se situe dans la gamme de 3 à 7 $\mu$m. Un second détecteur infra-rouge (3), dont la largeur de bande spectrale se situe dans la gamme de 10-20 $\mu$m, est susceptible de détecter des gradients de température à partir de 0,2 à 0,5 °C pour détecter et mesurer des intensités locales dans des métallisations et dans des connections conductrices.

Il faut encore signaler que le rayonnement induit aussi un courant électrique se superposant au signal d'excitation de la source 4 et permet également de mettre en évidence les discontinuités de la structure. C'est notamment une des raisons pour lesquelles il est envisagé de réunir les signaux électriques de réponse du dispositif 1 et ceux issus des détecteurs 3 dans le module 8 en vue de procéder, par combinaison de ces signaux, à une évaluation des défauts de structure du dispositif 1. Ceci permet de réduire la durée de l'examen de façon significative. Il est donc possible de faire un examen des écarts dus à l'image, de ceux dus à la stimulation électrique et de ceux dus à une combinaison de ces signaux. Bien entendu, les images obtenues peuvent également être utilisées par un opérateur chargé de procéder lui-même à la comparaison.

**Revendications**

1. Procédé d'examen et de test d'un dispositif électrique, substrat ou capteur du type des circuits intégrés ou imprimés, selon lequel on détecte par balayage un rayonnement propre émis par ce dispositif consécutivement à sa stimulation, on forme des signaux électriques caractéristiques de ce rayonnement détecté et on compare ces signaux à des signaux de référence, caractérisé par le fait que ladite stimulation comporte, conjointement, l'envoi à travers ledit dispositif d'un signal électrique déterminé et l'irradiation simultanée de ce dispositif à partir d'au moins une source d'un type déterminé de caractéristiques connues, ledit rayonnement émis par ce dispositif résultant de l'interaction entre l'irradiation et la matière de la structure de ce dispositif traversé par ce signal électrique déterminé, aux endroits où cette structure présente des discontinuités.

2. Procédé selon la revendication 1, caractérisé par le fait que l'on compare la réponse dudit dispositif, capteur ou substrat, du signal électrique déterminé de stimulation traversant ce dispositif.

3. Procédé selon la revendication 1, caractérisé par le fait que la source d'irradiation est un laser pulsé à ions.

4. Procédé selon la revendication 1, caractérisé par le fait que la source d'irradiation est une source infra-rouge (2-50 microns).

5. Procédé selon la revendication 1, caractérisé par le fait que la source d'irradiation est une source à micro-ondes notamment à micro-ondes millimétriques.

6. Procédé selon la revendication 1, caractérisé par le fait que la source d'irradiation est une source de protons.

7. Procédé selon la revendication 1, caractérisé par le fait que la source d'irradiation est un faisceau d'électrons pulsés.

8. Procédé selon la revendication 1, caractérisé par le fait que la source d'irradiation est une source de neutrons.

9. Procédé selon la revendication 1, caractérisé par le fait que la source d'irradiation est une source de ions.

10. Procédé selon la revendication 1, caractérisé par le fait que la source d'irradiation est un laser à rayons X ou UV.

11. Procédé selon la revendication 1, caractérisé par le fait que la source d'irradiation est une source à résonance magnétique nucléaire (NMR).

12. Procédé selon la revendication 1, caractérisé par le fait que l'on recouvre la surface irradiée dudit dispositif d'une substance liquide apte à amplifier localement le rayonnement émis par cette surface.

13. Procédé selon la revendication 12, caractérisé par le fait que cette substance est un gaz liquide.

14. Procédé selon la revendication 12, caractérisé par le fait que cette substance est formée de cristaux liquides.

15. Procédé selon la revendication 1, caractérisé par le fait que l'on sélectionne au moins l'un des paramètres chimiques, électromagnétiques ou température du dispositif à tester.

16. Procédé selon les revendications 1 et 2, caractérisé par le fait que l'on procède à la combinaison des signaux électriques de réponse du dispositif électrique capteur ou substrat en vue de les comparer auxdits signaux de référence.

17. Procédé selon la revendication 1, caractérisé par le fait que l'on détecte un rayonnement propre émis par réflection par ledit dispositif consécutivement à sa stimulation.

18. Procédé selon la revendication 1, caractérisé par le fait que l'on détecte un rayonnement propre émis par transmission par ledit dispositif consécutivement à sa stimulation.

19. Procédé selon l'une des revendications 4 et 5, caractérisé par le fait que l'on détecte le rayonnement propre émis par ledit dispositif consécutivement à sa stimulation dans la région des ondes millimétriques de 20-600 GHz à l'aide d'un détecteur à photoconduction à mono-cristaux de telluride de cadmium/mercure, dans le mode à électrons chauds.

## Claims

1. A method of examining and testing an electric device or substrate or transducer such as an integrated or printed circuit, in which radiation emitted by the device itself after stimulation is detected by scanning, electric signals characteristic of the detected radiation are formed and the signals are compared with reference signals, characterised in that the stimulation comprises in combination sending a given electric signal through the device and simultaneously irradiating the device from at least one source of given type and having known characteristics, the said radiation emitted by the device being the result of the interaction of the irradiation with the material of the structure of the device through which the given electric signal travels, at places where the structure has discontinuites.

2. A method according to claim 1, characterised in that the response of the device, transducer of substrate is compared with the given stimulating electric signal travelling through the device.

3. A method according to claim 1, characterised in that the irradiation source is a pulsed ion laser.

4. A method according to claim 1, characterized in that the irradiation source is an infrared source (2-50 microns).

5. A method according to claim 1, characterised in that the irradiation source is a microwave, in particular millimetre microwave, source.

6. A method according to claim 1, characterised in that the irradiation source is a proton source.

7. A method according to claim 1, characterised in that the irradiation source is a beam of pulsed electrons.

8. A method according to claim 1, characterised in that the irradiation source is a neutron source.

9. A method according to claim 1, characterised in that the irradiation source is an ion source.

10. A method according to claim 1, characterised in that the irradiation source is an X-ray or UV laser.

11. A method according to claim 1, characterised in that the irradiation source is a nuclear magnetic resonance (NMR) source.

12. A method according to claim 1, characterised in that the irradiated surface of the device is covered with a liquid substance for locally amplifying the radiation emitted by the surface.

13. A method according to claim 12, characterised in that the substance is a liquid gas.

14. A method according to claim 12, characterised in that the substance is made up of liquid crystals.

15. A method according to claim 1, characterised in that at least one of the chemical, electromagnetic or temperature parameters of the device under test is selected.

16. A method according to claim 1 or 2, characterised in that the electric response signals of the electric device, transducer or substrate are combined in order to compare them with the reference signals.

17. A method according to claim 1, characterised by detecting radiation emitted by reflection by the device itself after being stimulated.

18. A method according to claim 1, characterised by detecting radiation emitted by transmission by the device itself after stimulation.

19. A method according to claim 4 or 5, characterised by detecting the radiation emitted by the device itself after being stimulated in the millimetre wave region from 20 to 600 GHz by a cadmium/mercury telluride monocrystal photoconduction detector in the hot electron mode.

## Patentansprüche

1. Untersuchungs- und Prüfungsverfahren für eine elektrische Vorrichtung, ein Substrat oder einen Meßfühler in der Art von integrierten oder gedruckten Schaltungen, nach welchem man durch Abtasten eine von dieser Vorrichtung nach ihrer Stimulierung ausgesandte Eigenstrahlung ermittelt ; man elektrische, für diese ermittelte Strahlung charakteristische Signale bildet und diese Signale mit Bezugssignalen vergleicht, dadurch gekennzeichnet; daß die Stimulierung gleichzeitig das Senden eines bestimmten elektrischen Signals quer über die Vorrichtung und die gleichzeitige Bestrahlung dieser Vorrichtung, ausgehend von wenigstens einer Quelle einer von bekannten Charakteristika festgelegten Art, erlaubt, wobei die dieser Vorrichtung ausgesandte Strahlung sich aus der Wechselwirkung zwischen der Bestrahlung und dem Material der Struktur dieser Vorrichtung, die von dem festgesetzten elektrischen Signal durchquert wird, an Stellen ergibt, wo diese Struktur Unterbrechungen aufweist.

2. Verfahren nach Anspruch 1, dadurch gekennzeichnet, daß man die Erwiderung der Vorrichtung, des Meßfühlers oder des Substrats mit dem durch Stimulierung bestimmten, diese Vorrichtung durchquerenden, elektrischen Signal vergleicht.

3. Verfahren nach Anspruch 1, dadurch gekennzeichnet, daß die Bestrahlungsquelle ein ionengepulster Laser ist.

4. Verfahren nach Anspruch 1, dadurch gekennzeichnet, daß die Bestrahlungsquelle eine Infrarotquelle (2 bis 50 Mikron) ist.

5. Verfahren nach Anspruch 1, dadurch gekennzeichnet, daß die Bestrahlungsquelle eine Mikrowellenquelle, insbesondere eine für Millimeter-Mikrowellen, ist.

6. Verfahren nach Anspruch 1, dadurch gekennzeichnet, daß die Bestrahlungsquelle eine Protonenquelle ist.

7. Verfahren nach Anspruch 1, dadurch gekennzeichnet, daß die bestrahlungsquelle ein Bündel gepulster Elektronen ist.

8. Verfahren nach Anspruch 1, dadurch gekennzeichnet, daß die Bestrahlungsquelle eine Neutronenquelle ist.

9. Verfahren nach Anspruch 1, dadurch gekennzeichnet, daß die Bestrahlungsquelle eine Ionenquelle ist.

10. Verfahren nach Anspruch 1, dadurch gekennzeichnet, daß die Bestrahlungsquelle ein Laser für X- oder UV-Strahlen ist.

11. Verfahren nach Anspruch 1, dadurch gekennzeichnet, daß die Bestrahlungsquelle eine Quelle für Nuklear-Magnetresonanz (NMR) ist.

12. Verfahren nach Anspruch 1, dadurch gekennzeichnet, daß man die bestrahlte Obefläche der Vorrichtung mit einer flüssigen Substanz überzieht, die in der Lage ist, die von dieser Oberfläche ausgesandte Strahlung örtlich zu verstärken.

13. Verfahren nach Anspruch 12, dadurch gekennzeichnet, daß diese Substanz ein flüssiges Gas ist.

14. Verfahren nach Anspruch 12, dadurch gekennzeichnet, daß diese Substanz von Flüssigkristallen gebildet wird.

15. Verfahren nach Anspruch 1, dadurch gekennzeichnet, daß man wenigstens einen der chemischen Parameter, der elektromagnetischen Parameter oder die Temperatur der zu prüfenden Vorrichtung auswählt.

16. Verfahren nach Ansprüchen 1 und 2, dadurch gekennzeichnet, daß man mit der Zusammenlegung der elektrischen Erwiderungssignale der elektrischen Vorrichtung, des Meßfühlers oder des Substrats im Hinblick auf das Vergleichen derselben mit den Bezugssignalen fortfährt.

17. Verfahren nach Anspruch 1, dadurch gekennzeichnet, daß man eine Eigenstrahlung ermittelt, die durch Reflektion von der Vorrichtung nach ihrer Stimulierung ausgesandt wird.

18. Verfahren nach Anspruch 1, dadurch gekennzeichnet, daß man eine Eigenstrahlung ermittelt, die durch Transmission von der Vorrichtung nach ihrer Stimulierung ausgesandt wird.

19. Verfahren nach einem der Ansprüche 4 und 5, dadurch gekenzeichnet, daß man die von der Vorrichtung nach ihrer Stimulierung ausgesandte Eigenstrahlung im Bereich der Millimeterwellen von 20 bis 600 GHz mit Hilfe eines lichtleitenden Detektors mit Einkristallen aus Cadmium/Quecksilber-Tellurid in der Heißelektronenbetriebsart ermittelt.

FIG. 1

FIG. 2

Excitation

Ondes rétro-diffusées
(IR, UV, MMW)

IR, MMW rayonnées

Electrons secondaires

Electrons rétro-diffusés

Rayons X

Ions rétro-diffusés

Electrons Auger

Cathodoluminescence

Electrons à faible perte

IC

Electrons transmis
Ondes transmises
Ions transmis

Ions absorbés
Ondes absorbées
Electrons absorbés

## FIG. 3

IR

Electrons Auger

Electrons secondaires

$8\mu$
à
$20\mu$

Electrons + Ions + Ondes
rétro-diffusés

Rayons X et ondes millimétriques (MMW)

## FIG. 4

FIG. 5